# EUROPÄISCHE PATENTANMELDUNG

(11) **EP 1 271 778 A2**
(43) Veröffentlichungstag der Anmeldung: **02.01.2003**
(21) Anmeldenummer: 02013091.0
(22) Anmeldetag: 13.06.2002
(51) Int. Cl.: H03H 17/02

(54) **Elektrisches Filter mit Sperrverhalten für eine vorbestimmte Sperrfrequenz**

(30) Priorität: 28.06.2001 DE 10131224
(71) Anmelder: STMicroelectronics GmbH, 85630 Grasbrunn (DE)
(72) Erfinder: Henkel, Johann, 83024 Rosenheim (DE)
(74) Vertreter: Hirsch, Peter, Dipl.-Ing.

(57) **Zusammenfassung**

Elektrisches Tiefpassfilter mit Sperrverhalten für eine vorbestimmte Sperrfrequenz, aufweisend eine Reihenschaltung mit einem FIR-Filter und einem IIR-Filter, wobei die Parameter des FIR-Filters im Wesentlichen auf das Sperrverhalten bei der Sperrfrequenz und die Parameter des IIR-Filters im Wesentlichen auf das Tiefpassverhalten abgestimmt sind. Mit einem derartigen Filter läßt sich mit relativ geringem Schaltungsaufwand und mit hoher Stabilität gegenüber Schwingneigung ein gutes Tiefpassverhalten mit sehr starker Dämpfung der zu sperrenden Frequenz erreichen. Ein solches Filter eignet sich beispielsweise als Schleifenfilter einer PLL-Schaltung.

## Beschreibung

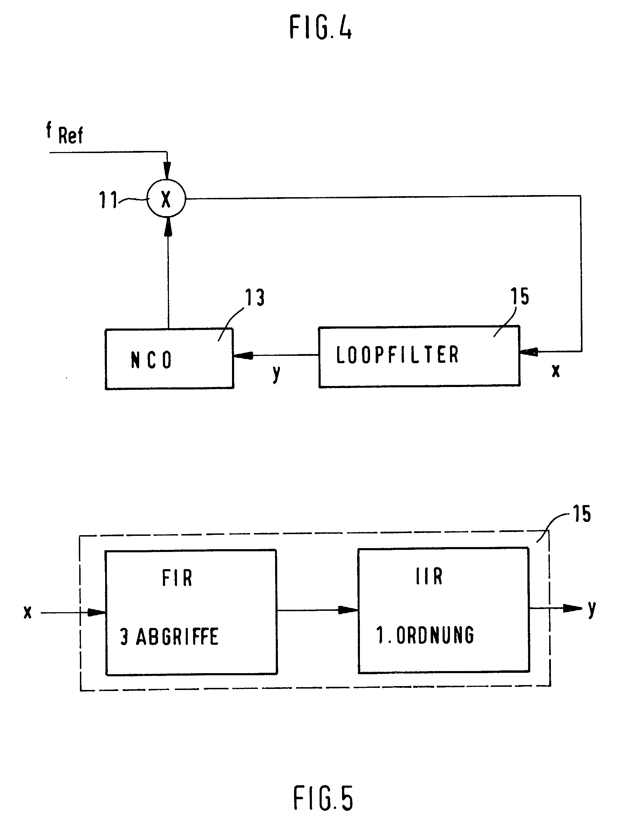

Elektrische Filter mit Sperrverhalten für eine vorbestimmte Sperrfrequenz werden beispielsweise als Schleifenfilter für PLL-Schaltungen benötigt. Ein Prinzip-Blockschaltbild einer PLL-Schaltung ist in Fig. 4 gezeigt und weist eine Mischstufe 11 auf, die einerseits eine Referenzfrequenz und andererseits eine Oszillatorfrequenz von einem steuerbaren Oszillator (NCO: Numerical Controlled Oscillator) 13 erhält. Das Mischprodukt wird dem Oszillator 13 über ein Schleifenfilter 15 zugeführt. Das Mischprodukt der Mischstufe 11 enthält eine Summenfrequenz und eine Differenzfrequenz, welche durch die Summe bzw. die Differenz der beiden der Mischstufe 11 zugeführten Frequenzen gebildet werden. Praktisch und insbesondere im eingerasteten Zustand der PLL-Schaltung ist die Summenfrequenz doppelt so groß wie die Referenzfrequenz.

Das Schleifenfilter 15 hat zwei Aufgaben zu erfüllen. Einerseits soll es die Summenfrequenz sperren und andererseits soll es die Differenzfrequenz glätten oder mitteln, um dem Oszillator 13 eine geeignete Frequenzsteuergröße zuführen zu können.

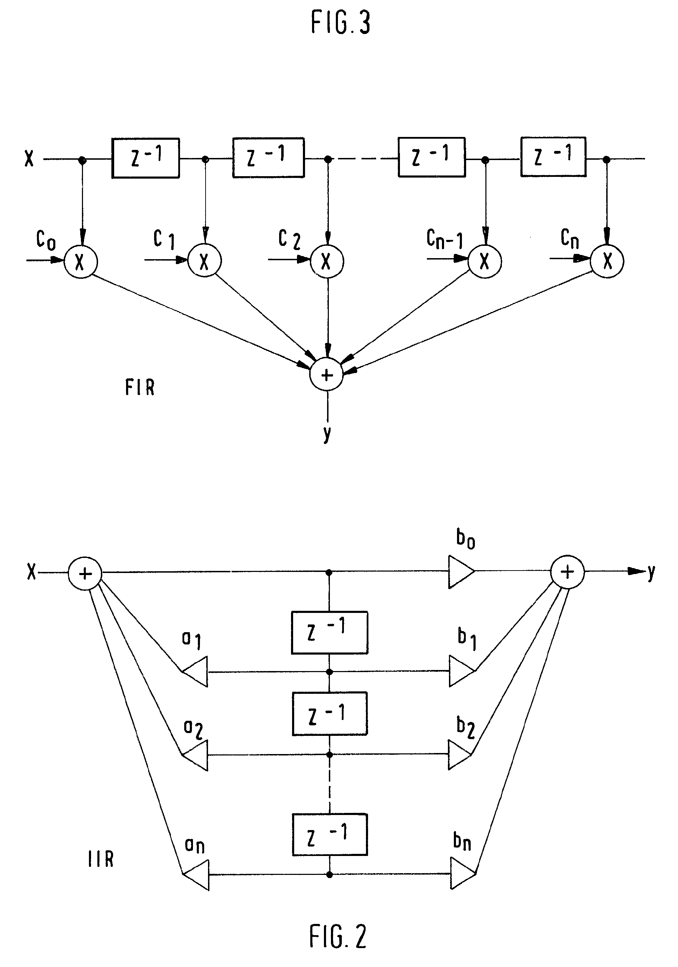

Bisher hat man als Schleifenfilter entweder ein analoges LC-Filter verwendet oder ein IIR-Filter, wobei IIR für Infinite Impuls Response steht. Der prinzipielle Aufbau eines IIR-Filters ist in Fig. 2 gezeigt und ist an sich bekannt. Ein solches Filter weist n Zeitglieder oder Verzögerungsstufen Z⁻¹, mehrere Koeffizientenstufen a1- an und b0-bn und zwei Summierglieder auf. Aufgrund seiner Rückkopplungsstruktur weist das IIR-Filter ungewünschte Schwingneigung auf. Um sowohl das gewünschte Tiefpaßverhalten als auch das Sperrverhalten zu erreichen, muß ein solches IIR-Filter mit relativ viel Stufen aufgebaut werden, was nicht nur eine entsprechend hohe Anzahl elektronischer Komponenten erfordert sondern die Schwingneigung erhöht.

Als weiterer Filtertyp ist das FIR-Filter bekannt, wobei FIR für Finite Impuls Response steht. Der prinzipielle Aufbau eines FIR-Filters ist in Fig. 3 gezeigt. Bei diesem Filter ist eine Anzahl von Zeit- oder Verzögerungsgliedern Z⁻¹ in Reihe geschaltet, werden die benötigten Koeffifzienten mit Multiplikatoren C0-Cn erzeugt und werden die Ausgangssignale der Multiplikatoren in einer Summierstufe zum Ausgangssignal zusammengefaßt. Da ein derartiges Filter keine Rückkopplungsstruktur aufweist, ist es unproblematisch hinsichtlich Schwingneigung. Mit einem solchen Filter läßt sich zwar ein gutes Sperrverhalten für die Sperrfrequenz, das heißt, die Summenfrequenz, erreichen. Für ein zufriedenstellendes Tiefpaßverhalten müßte ein derartiges Filter jedoch mit einer relativ großen Anzahl von Filterstufen aufgebaut werden, was einen entsprechend hohen Aufwand bedeutet.

Ein digitales FIR-Kerbfilter mit einem Aufbau der in Fig. 3 gezeigten Art ist aus der JP 04-249913 AA bekannt, wobei mit diesem Filter ein unerwünschtes Signal eliminiert werden soll.

Die EP 0 714 201 A2 beschreibt eine digitale Phasenverriegelungsschleife, die zur Trägerrückgewinnung in einem Signalprozessorsystem für digitale Fernsehsignale verwendet wird. Die Phasenverriegelungsschleife weist unter anderem einen Phasendetektor, einen spannungsgesteuerten Oszillator und ein als FIR-Filter ausgebildetes Kerbfilter auf. Das FIR-Filter bildet zwei Kerben, mittels welchen die Bildträgerfrequenz und die Farbträgerfrequenz gesperrt werden sollen.

Der Erfindung liegt die Aufgabe zugrunde, ein Filter verfügbar zu machen, das bei relativ geringem Schaltungsaufwand und mit hoher Stabilität gegenüber Schwingneigung ein gutes Tiefpaßverhalten mit starker Dämpfung der Sperrfrequenz aufweist und daher insbesondere als Schleifenfilter für eine PLL-Schaltung gut geeignet ist.

Diese Aufgabe wird mit einem elektrischen Tiefpaßfilter der im Patentanspruch 1 angegebenen Art gelöst.

Ein erfindungsgemäßes Tiefpaßfilter zeichnet sich durch eine Reihenschaltung mit einem FIR-Filter und einem IIR-Filter aus, wobei die Parameter des FIR-Filters im wesentlichen auf das Sperrverhalten bei der Sperrfrequenz und die Parameter des IIR-Filters im wesentlichen auf das Tiefpaßverhalten abgestimmt sind.

Bei Verwendung als Schleifenfilter für eine PLL-Schaltung kommt man bei einem erfindungsgemäßen Tiefpaßfilter mit einem FIR-Filter mit drei Zeitgliedern und einem IIR-Filter mit einem Zeitglied aus. Ein solches Filter weist bei relativ geringem Schaltungsaufwand sowohl ein gutes Tiefpaßverhalten als auch ein gutes Sperrverhalten für die Sperrfrequenz auf.

Bei Verwendung eines erfindungsgemäßen Tiefpaßfilters als Schleifenfilter in einer PLL-Schaltung wird die Summenfrequenz, nämlich das Doppelte der Referenzfrequenz, mit sehr hoher Dämpfung vom Oszillator ferngehalten, während die dem Oszillator zugeführte Steuergröße aufgrund der Tiefpaßfilterung durch das Schleifenfilter gut geglättet bzw. gemittelt ist.

Aufgrund der geringen Anzahl der erforderlichen Zeitglieder weist ein erfindungsgemäßes Filter eine niedrige Zeitkonstante auf, was eine kurze Einschwingzeit des Filters und bei dessen Verwendung als Schleifenfilter einer PLL-Schaltung, eine kurze Einrastzeit der PLL-Schaltung mit sich bringt.

Um die gleiche Sperrdämpfung für die Sperrfrequenz zu erreichen wie mit einem herkömmlicherweise für Schleifenfilter von PLL-Schaltungen verwendeten IIR-Filter ist bedeutend weniger Schaltungsaufwand und damit Kostenaufwand erforderlich.

Die Reihenfolge von FIR-Filter und IIR-Filter in der Reihenschaltung eines erfindungsgemäßen Filters kann beliebig gewählt werden.

Da man erfindungsgemäß zwei Filtertypen hintereinander schaltet, von denen das eine mehr für Tiefpaßfilterung und das andere mehr für Sperrfrequenzdämpfung geeignet ist, kann man sich bei jedem dieser beiden Filter auf die Optimierung hinsichtlich seiner Funktion konzentrieren und kann somit ein sehr gutes Gesamtfilterverhalten erzielen. Das IIR-Filter kann man auf die Tiefpaßfilterung optimieren, weil man nicht gleichzeitig auf Dämpfungserfolg hinsichtlich der Sperrfrequenz achten muß, während man das FIR-Filter hinsichtlich des Dämpfungsverhaltens bei der Sperrfrequenz optimieren kann, weil man nicht auf den Tiefpaßfilterungserfolg achten muß. Da jedes dieser beiden Filter nur nach einem der beiden Filtergesichtspunkte dimensioniert und optimiert zu werden braucht, kann jedes dieser beiden Filter mit wenig Schaltungsaufwand auskommen.

Ein erfindungsgemäßes Filter eignet sich überall dort, wo gleichzeitig ein gutes Tiefpaßverhalten und eine hohe Sperrdämpfung für eine Sperrfrequenz erforderlich sind.

Die Erfindung wird nun anhand von Ausführungsformen näher erläutert.

In den Figuren zeigen:
Fig. 1 einen Aufbau eines erfindungsgemäßen Filters;
Fig. 2 einen Aufbau eines an sich bekannten IIR-Filters;
Fig. 3 einen Aufbau eines an sich bekannten FIR-Filters;
Fig. 4 einen Aufbau einer an sich bekannten PLL-Schaltung;
Fig. 5 ein Prinzip-Blockschaltbild eines erfindungsgemäßen Filters;
Fig. 6 einen Dämpfungsverlauf eines FIR-Filters;
Fig. 7 einen Dämpfungsverlauf eines IIR-Filters; und
Fig. 8 einen Dämpfungsverlauf eines erfindungsgemäßen Filters.

Nachfolgend wird eine Ausführungsform eines erfindungsgemäßen Filters betrachtet, die besonders als Schleifenfilter für eine PLL-Schaltung geeignet ist, deren Summenfrequenz bei 38 KHz liegt.

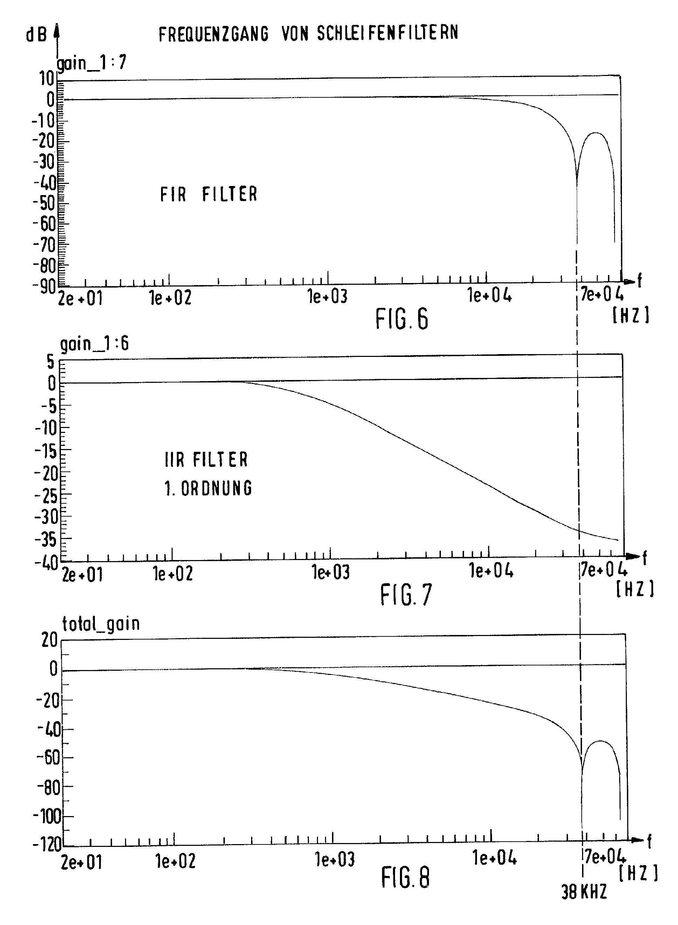

Anhand der Figuren 6 und 7 wird zunächst das Dämpfungsverhalten betrachtet, welches sich erreichen läßt, wenn man nur ein FIR-Filter oder nur ein IIR-Filter verwendet. Mit dem FIR-Filter läßt sich gemäß Fig. 6 eine schmalbandige und hohe Dämpfung der Summenfrequenz erreichen, wenn man eine der Nullstellen des FIR-Filters auf die Summenfrequenz legt. Wie aus Fig. 6 ersichtlich ist, ist bis in die Nähe der Summenfrequenz praktisch keine Tiefpaßfilterung gegeben.

Das in Fig. 7 gezeigte Dämpfungsverhalten des IIR-Filters zeigt reines Tiefpaß-Dämpfungsverhalten. Kerbenförmige Sperrdämpfungsstellen (in Übernahme aus dem englischsprachigen Raum auch Notches genannt) wären nur mit zusätzlichem Schaltungsaufwand und einer nachteiligen Verlängerung der Filtergruppenlaufzeit möglich.

Das in Fig. 8 gezeigte Dämpfungsverhalten eines erfindungsgemäßen Filters mit einer Reihenschaltung aus einem FIR-Filter und einem IIR-Filter zeigt eine hohe Sperrfrequenzdämpfung bei der Summenfrequenz und ein gutes Tiefpaßfilterverhalten unterhalb der Summenfrequenz.

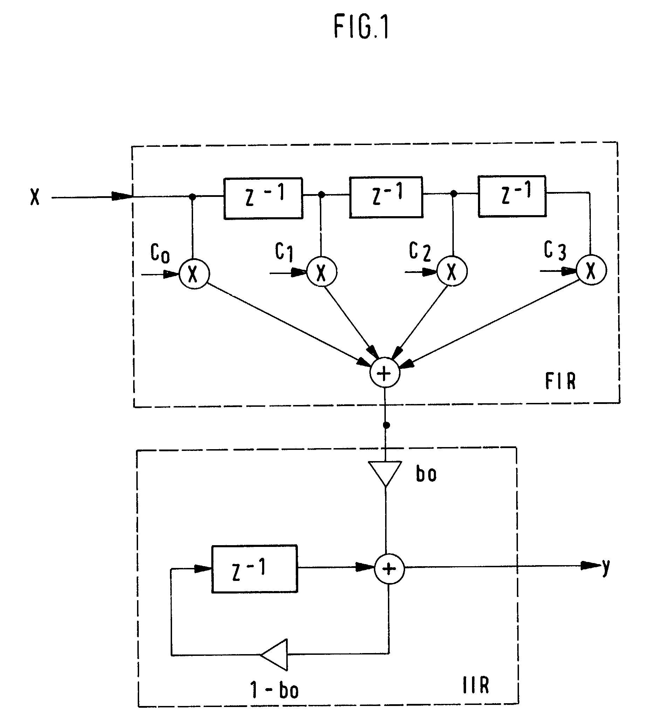

Dies erreicht man mit einem Filter mit dem in Fig. 1 gezeigten Aufbau. Hinsichtlich des FIR-Filterteils kommt man mit drei Verzögerungsgliedern Z⁻¹, vier Multiplikatorschaltungen, gekennzeichnet durch ein X, und ein Summierglied, gekennzeichnet durch ein +, aus. Hinsichtlich des IIR-Filterteils reicht eine einzige Stufe aus, also ein IIR-Filter erster Ordnung, das lediglich ein Verzögerungsglied Z⁻¹, zwei Faktor-Multiplikatoren, gekennzeichnet mit b0 und 1-b0, und ein Summierglied aufweist. Insgesamt benötigt man somit für das Gesamtfilter nur vier Verzögerungsglieder, so daß das Gesamtfilter eine kurze Gesamtzeitkonstante aufweist und einen Schaltungsaufwand, der vergleichsweise gering ist gegenüber herkömmlichen Filterlösungen mit nur einem Filtertyp.

Bei dem FIR-Filterteil läßt sich die Nullstelle, welche zu der hohen Sperrdämpfung bei der Summenfrequenz führt, mit den Parametern C0-C3 sehr gut einstellen. Die Mittelungs- oder Glättungsfunktion des IIR-Filterteils läßt sich durch die Faktoren b0 und 1-b0 einstellen.

## Patentansprüche

1. Elektrisches Tiefpassfilter mit Sperrverhalten für eine vorbestimmte Sperrfrequenz, aufweisend eine Reihenschaltung mit einem FIR-Filter und einem IIR-Filter, wobei die Parameter des FIR-Filters im Wesentlichen auf das Sperrverhalten bei der Sperrfrequenz und die Parameter des IIR-Filters im Wesentlichen auf das Tiefpassverhalten abgestimmt sind.

2. Tiefpassfilter nach Anspruch 1, bei welchem das FIR-Filter mit drei Zeitgliedern (Z⁻¹) und das IIR-Filter mit einem Zeitglied (Z⁻¹) aufgebaut sind.

3. Verwendung eines Tiefpassfilters nach Anspruch 1 oder 2 als Schleifenfilter einer PLL-Schaltung.

4. PLL-Schaltung mit einem Schleifenfilter in Form eines Tiefpassfilters nach Anspruch 1 oder 2.

5. PLL-Schaltung nach Anspruch 4 mit einer Referenzfrequenzquelle, einem hinsichtlich der Oszillatorfrequenz steuerbaren Oszillator (13), einer Mischstufe (11) und dem zwischen Mischstufe (11) und Oszillator (13) geschalteten Schleifenfilter (15), wobei der Mischstufe (11) die Referenzfrequenz und die Oszillatorfrequenz zugeführt werden, die Mischstufe (11) eine Summenfrequenz aus Referenzfrequenz und Oszillatorfrequenz und eine Differenzfrequenz aus Referenzfrequenz und Oszillatorfrequenz erzeugt, dem Oszillator (13) das Ausgangssignal des Schleifenfilters (15) als Steuergröße für die Oszillatorfrequenz zugeführt wird, das FIR-Filter auf Sperrung der Summenfrequenz und das IIR-Filter auf Glättung der Steuergröße ausgelegt sind.
